# FASCICULE DE BREVET EUROPEEN

(11) **EP 3 158 105 B1**
(45) Date de publication et mention de la délivrance du brevet: **24.03.2021**
(21) Numéro de dépôt: 15733818.7
(22) Date de dépôt: 10.06.2015
(51) Int. Cl.: F16H 53/02, F01L 1/047, C23C 16/02, C23C 16/26, C23C 16/04, C23C 14/04, C23C 14/06

(54) **PROCÉDÉ DE REVÊTEMENT EN CARBONE DLC DU NEZ DES CAMES D'UN ARBRE À CAME, ARBRE À CAMES AINSI OBTENU ET INSTALLATION POUR LA MISE EN OEUVRE DE CE PROCÉDÉ**
VERFAHREN ZUM BESCHICHTEN DER NASE DER NOCKEN EINER NOCKENWELLE MIT DLC, SO HERGESTELLTE NOCKENWELLE UND ANLAGE ZUR DURCHFÜHRUNG DIESES VERFAHRENS
METHOD FOR COATING THE NOSE OF THE CAMS OF A CAMSHAFT WITH DLC, CAMSHAFT OBTAINED IN THIS WAY AND FACILITY FOR IMPLEMENTING SAID METHOD

(30) Priorité: 18.06.2014 FR 1455597
(43) Date de publication de la demande: 26.04.2017
(73) Titulaire: HYDROMECANIQUE ET FROTTEMENT, 42160 Andrézieux-Bouthéon (FR)
(72) Inventeur: HENRY, Sandrine, F-42740 Saint-Paul en Jarez (FR); HEAU, Christophe, 42650 Saint-Jean-Bonnefonds (FR)
(74) Mandataire: Santarelli
(86) Numéro de dépôt international: PCT/FR2015/051528
(87) Numéro de publication internationale: WO 2015/193584

(56) Documents cités:
- EP-A1- 2 628 817
- EP-A2- 2 682 230
- WO-A1-01/79585
- WO-A1-2009/063788

## Description

L'invention concerne un procédé de revêtement des cames d'un arbre à cames, une came ainsi obtenue, un arbre à cames ainsi obtenu et une installation pour la mise en oeuvre du procédé. Elle se rapporte en effet à l'application de revêtements durs sur des composants mécaniques, tels que des cames, visant à réduire les efforts mécanique induits par le contact avec la pièce antagoniste, typiquement un linguet, un poussoir ou un culbuteur. Elle vise tout particulièrement le domaine des moteurs à combustion interne, pour automobiles, motos ou poids lourds, mettant en œuvre des arbres à cames.

Dans le cas des contacts came/linguet et came/poussoir, le traitement du linguet (ou du poussoir), notamment par un revêtement de type DLC, est connu de l'homme de l'art. Il est rappelé que l'acronyme DLC désigne un revêtement dur à base de carbone amorphe (« Diamond-like Carbon »). L'intérêt d'appliquer ce genre de revêtement est de diminuer le coefficient de frottement entre la came et le linguet ou le poussoir, et par là de réduire la consommation de carburant et l'émission de dioxyde de carbone (CO2) du véhicule. L'application d'un tel revêtement est devenue nécessaire à cause de l'augmentation croissante de la pression de contact entre ces composants (cette augmentation de la pression de contact résulte de la tendance constante à diminuer la dimension des pièces en vue d'en réduire la masse et l'énergie perdue à cause de l'inertie).

Toutefois, malgré les excellentes propriétés de frottement des revêtements DLC, il a été constaté que l'usage de certaines huiles additivées (c'est-à-dire contenant des additifs), en combinaison avec des revêtements DLC, conduisait parfois à des résultats non satisfaisants en termes de résistance à l'usure et de réduction de frottement. C'est notamment le cas lors de l'utilisation d'huiles contenant des additifs de réduction de frottement à base de soufre et de molybdène tels que les MoDTC (Molybdenum Dithio-Carbamate) ; un intérêt de ces MoDTC est qu'une réaction tribo-chimique conduit à la formation d'un film de protection, aussi appelé tribofilm, sur les surfaces métalliques en présence, typiquement la surface des cames dans un système came/linguet ou came/poussoir. Or on a constaté qu'il se produisait une réaction chimique non désirée entre les éléments complexes de ce tribofilm (formé sur les cames) et le revêtement DLC appliqué sur le linguet (ou le poussoir) qui conduit à une dégradation accélérée du revêtement, aussi appelée tribocorrosion.

Comme le tribofilm ne se forme que sur des surfaces métalliques nues, c'est à dire non revêtues, ou sur des revêtements présentant un fort caractère métallique (c'est-à-dire formés d'éléments métalliques pour une part importante), une solution consiste à revêtir les deux pièces antagonistes, c'est-à-dire la came et le linguet (ou le poussoir), avec un revêtement ne permettant pas la formation de ce tribofilm, par exemple avec du DLC. En l'absence de tribofilm dans la zone de contact, aucune réaction chimique ne peut se produire entre les additifs et le revêtement DLC. Ce dernier peut alors remplir sa fonction de réduction du frottement sans dégradation du fait de la présence des MoDTC.

Un tel revêtement de l'arbre à cames a déjà été envisagé depuis plusieurs années. Toutefois, le coût associé au revêtement d'un arbre à cames a eu jusqu'à présent pour effet de restreindre l'application d'un revêtement DLC sur un arbre à cames au seul domaine de la compétition automobile (Formule 1 en particulier), le coût étant considéré comme étant rédhibitoire dans le domaine de la construction automobile en général.

Le coût important du revêtement d'un arbre à cames provient notamment du fait qu'un tel arbre a un encombrement important qui ne permet pas de traiter simultanément un grand nombre d'arbres ; en outre, la complexité de la forme d'un arbre à cames en rend le traitement complexe.

Pourtant, il est apparu que les zones d'un arbre à cames qui sont réellement utiles dans la coopération avec les linguets ou les poussoirs représentent une faible fraction de la surface globale (moins de 25%), de sorte qu'il semble superflu de revêtir la totalité de la surface d'un arbre à cames. Cela, pris en combinaison avec le fait qu'on connaît désormais des arbres à cames résultant de l'assemblage d'un arbre et d'une pluralité de cames, permet d'envisager de ne munir d'un revêtement protecteur que les cames d'un arbre à cames, sous réserve de pouvoir, ensuite, intégrer ces cames au sein d'un arbre à cames d'une manière ne conduisant pas à une quelconque détérioration de ce revêtement.

Toutefois, la réduction de coût permise par le fait de ne traiter que les cames d'un arbre à cames ne semble pas suffire pour descendre dans des gammes de coûts permettant une généralisation du traitement des arbres à cames.

Une alternative semble consister à développer un revêtement de type DLC présentant une résistance chimique aux additifs de type MoDTC contenus dans ces huiles de nouvelle génération ; on peut à cet égard se référer au document WO - 2012/116818 A1. Toutefois, cette alternative revient à générer une source supplémentaire de coût, réduisant l'avantage économique consistant à ne revêtir qu'une partie des arbres à cames.

Le document EP 2 628 817 concerne une pièce comportant au moins une première couche de grande dureté et de haute résistance à l'usure (notamment DLC) et une seconde couche déposée par ALD sur la première couche, en respectant des conditions dimensionnelles particulières. Pour ce faire, ce document décrit une installation comportant une table munie de dispositifs de maintien pour les pièces auxquelles un potentiel est appliqué par un circuit au travers de la table, où la table, les arbres des dispositifs de maintien pour les pièces et les pièces peuvent être mis en rotation.

L'invention a pour objet de traiter un arbre à cames au moyen d'un revêtement protecteur, tel qu'un revêtement en DLC, pour un coût suffisamment faible pour permettre une généralisation à grande échelle d'un tel traitement dans le domaine de la propulsion automobile au sens large (intégrant non seulement les automobiles, mais aussi les motos et les poids-lourds), tout en permettant le maintien de bonnes performances de frottement contre des pièces également traitées par un tel revêtement protecteur, tel que du DLC, même en présence d'huiles comportant des additifs tels que du MoDTC.

L'invention propose à cet effet un procédé de traitement des cames d'un arbre à cames pour véhicule à combustion interne pour en réduire le coefficient de frottement vis-à-vis d'une pièce antagoniste en une zone munie d'un revêtement dur à base de carbone amorphe de type Diamond Like Carbon ou DLC, selon lequel on dispose les cames sur un carrousel en sorte d'aligner leurs longueurs suivant des rayons de ce carrousel selon une configuration fixe entre les cames et le carrousel dans laquelle toutes les cames portées par ce carrousel sont à une même distance de l'axe de rotation du carrousel en ayant leurs nez orientés vers l'extérieur du carrousel, on dispose ce carrousel et les cames dans une enceinte que l'on met sous vide en sorte d'assurer un décapage de ces cames, on met ce carrousel en rotation autour de son axe par rapport à une source de revêtement en sorte de déposer un revêtement dur à base de carbone amorphe de type Diamond Like Carbon ou DLC, sélectivement sur la fraction de la tranche des cames qui est orientée vers l'extérieur du carrousel, et on enlève les cames vis-à-vis du carrousel avant de les assembler au sein d'un arbre à cames.

De manière classique, le dépôt sous vide est un dépôt physique (« PVD » pour Physical Vapor Déposition) ou chimique (« PACVD » pour Plasma Assisted Chemical Vapor Déposition), notamment.

On comprend que, puisqu'une rotation dont l'axe est repoussé à l'infini devient une translation, on comprend que l'invention se généralise au cas où les cames sont disposées en sorte que leurs longueurs sont orientées parallèlement les unes aux autres, perpendiculairement à une trajectoire de défilement relatif par rapport à la source de revêtement.

En outre, l'invention se généralise au cas où, au lieu d'être horizontalement en regard des cames (et inversement), la source de revêtement est au-dessus (voire en dessous) des cames, avec par exemple une rotation autour d'un axe horizontal, ou une translation des cames sous, ou au-dessus, de la source de revêtement, ou même dans le cas où les cames viennent en regard de la source selon une quelconque direction inclinée ; or de telles configurations n'étaient guère réalistes dans les configurations de l'état de la technique.

Ainsi, de manière très générale, l'invention propose un procédé de traitement des cames d'un arbre à cames pour véhicule à combustion interne pour en réduire le frottement vis-à-vis d'une pièce antagoniste en une zone munie d'un revêtement dur à base de carbone amorphe du type Diamond Like Carbon ou DLC, ces cames ayant un évidement central, une tranche présentant une zone circulaire et une portion allongée formant un nez en ayant une longueur définie par la dimension maximale mesurée depuis leur nez jusqu'à la zone circulaire, procédé selon lequel on dispose les cames sur un support, on amène ce support dans une enceinte que l'on met sous vide en sorte d'assurer un décapage des cames, on met ce support en mouvement relatif suivant une trajectoire de défilement par rapport à une source d'un matériau de revêtement dur à base de carbone amorphe de type Diamond Like Carbon ou DLC et on enlève ces cames vis-à-vis du support avant de les assembler au sein d'un arbre à cames, caractérisé en ce que, le support comportant une pluralité de tiges parallèles entre elles, fixes par rapport à ce support et distribuées de manière régulière à une même distance de la trajectoire de défilement en étant orientées perpendiculairement à la direction d'émission de la source de matériau de revêtement lorsqu'elles viennent en regard de cette source, on dispose les cames sur le support selon une configuration fixe et dense en faisant traverser les évidements par les tiges, les tiges étant réparties de manière régulière le long de cette trajectoire en sorte que les cames engagées sur une tige soient au moins approximativement au contact avec les cames engagées sur les tiges les plus proches, les cames dans cette configuration fixe et dense sont amenées successivement, selon cette trajectoire de défilement, en regard de la source de revêtement avec des orientations sensiblement identiques et à des distances sensiblement identiques par rapport à cette source, en sorte de déposer un revêtement sélectivement sur les fractions des tranches des cames qui sont orientées vers ladite source, sur au plus le nez des cames.

Une trajectoire de défilement peut être définie comme étant la ligne tracée par un point choisi arbitrairement au sein du support lors de son défilement devant la source lors du mouvement relatif ; on comprend qu'il est donc possible de définir une pluralité de trajectoires de défilement selon les points choisis mais que ces diverses trajectoires sont parallèles de sorte qu'il est possible de définir l'orientation des cames par rapport à une telle trajectoire de défilement sans avoir à préciser le point choisi arbitrairement.

Dans la suite, le support est désigné comme étant un plateau lorsqu'il est formé d'une plaque plane, habituellement horizontale, voire d'un ensemble d'une ou plusieurs plaques parallèles, pouvant être verticales. Lorsqu'un tel plateau ou un tel ensemble est en rotation, on peut le désigner sous le vocable de carrousel.

Il est ici implicite que le revêtement considéré a une épaisseur de l'ordre du micron (pas plus de quelques microns), ce qui correspond à ce que l'on appelle une couche mince. Il en découle que les procédés de dépôt d'un tel revêtement sont des procédés de formations de couches minces.

Il est rappelé que la tranche d'une came désigne la zone, en pratique étroite, qui est délimitée par les faces parallèles de cette came. L'invention n'impose pas que des précautions soient prises pour éviter que du matériau de revêtement soit déposé sur ces faces parallèles. Le nez représente la partie la plus effilée que présente la tranche de la came, en pratique la plus éloignée de l'évidement que présente habituellement une telle came, ce qui explique que la longueur d'une came se mesure entre ce nez et la zone circulaire que comporte sa tranche.

L'invention tire profit de ce que, en fin de compte, seule une partie de la tranche d'une came a besoin d'être munie d'un revêtement protecteur tel que du DLC, ce qui permet une grande simplification des modalités de formation d'un tel revêtement, en combinaison avec un accroissement du nombre de cames pouvant être traité simultanément, pour des conditions de traitement données, dans un volume donné.

En effet, l'invention tire parti du fait qu'il suffit en pratique de revêtir seulement le nez des cames, voire une partie seulement de ces nez, pour éviter une dégradation du revêtement de la pièce antagoniste, même en présence d'une huile telle qu'une huile contenant des MoDTC. Plus précisément, il est apparu inutile de revêtir la partie de la came (couramment appelée partie arrière) qui est à une distance minimale vis-à-vis de l'axe de rotation de la came ; même si cette partie vient parfois, en service, en contact avec la pièce antagoniste en présence d'une huile contenant des MoDTC, ce contact ne se fait pas, en pratique, avec une pression suffisante pour que la présence d'un tribofilm à la surface de la zone non revêtue puisse favoriser la réaction de dégradation du DLC.

Or il apparait que cette zone à distance minimale de l'axe de rotation de la came s'étend en pratique sur un angle de l'ordre de 180° autour de cet axe, ce qui signifie que, pour revêtir une came en dehors de cette zone à distance minimale, il n'est pas nécessaire de prévoir une rotation de cette came sur le carrousel classiquement mis en œuvre pour assurer la formation d'un revêtement protecteur. On comprend toutefois que l'invention n'implique pas de prendre des dispositions particulières pour éviter le dépôt du matériau de revêtement au-delà de la zone de frottement ; il est même envisageable que du matériau soit déposé au-delà de cette zone de frottement avec la pièce antagoniste.

En effet, de manière habituelle, pour assurer la formation d'un revêtement sur une pièce à partir d'une source de matériau de revêtement, on dispose cette pièce sur un carrousel qui est lui-même monté sur un plateau tournant conçu en sorte de présenter sa périphérie en regard de ladite source au sein d'une machine de dépôt sous vide; sur ce plateau tournant sont montés plusieurs carrousels commandés en rotation autour de leurs axes respectifs, parallèles à l'axe du plateau, ce qui confère à leur rotation un caractère planétaire ; et chaque pièce montée sur chaque carrousel est adaptée à tourner, sur ce carrousel, de manière à présenter chaque zone de sa périphérie à la source. Cela signifie qu'il y a une combinaison de trois mouvements de rotation (la rotation des pièces par rapport à leur carrousel, la rotation de ce carrousel par rapport au plateau et la rotation du plateau dans la machine). Ces rotations se font classiquement autour d'axes verticaux.

Puisque, selon l'invention, on renonce à exposer la totalité de la tranche des cames à la source, il n'est plus nécessaire de prévoir une rotation des pièces autour de leur axe (ce que ferait l'homme de l'art), ce qui permet de réduire le nombre de rotations (ou de mouvements) à commander. C'est une première simplification, qui induit une réduction de coût.

En outre, puisqu'il n'est plus nécessaire de prévoir une rotation des pièces par rapport à leur support, il devient possible de disposer les pièces à traiter, sur un support donné, de manière bien plus dense que dans le cas d'une triple rotation ; il en découle que, lors d'une phase de traitement, il est possible de traiter un nombre accru de pièces, ce qui constitue un autre motif de réduction de coût.

Enfin, puisqu'on ne revêt qu'une partie de la tranche des pièces, il y a une réduction de la quantité de matériau de revêtement, ce qui constitue un autre motif de réduction de coût.

Pourtant, en pratique, on pouvait avoir des doutes sur le fait qu'un revêtement sur une partie seulement de la surface des tranches des cames aurait une adhérence satisfaisante en service, sans subir de dégradation lors du montage des cames au sein d'un arbre à cames (comme indiqué ci-dessus, il s'agit de simples couches minces). Il est toutefois apparu que cela n'avait pas de conséquence significative (sous réserve, bien sûr, que le revêtement soit déposé avec le soin habituel).

Il mérite d'être souligné que le traitement des cames selon l'invention n'implique pas, lorsqu'on choisit un mouvement de rotation autour d'un axe vertical, de changement significatif dans l'installation de revêtement, à ceci près qu'on simplifie la structure des carrousels, en y supprimant la troisième rotation.

A l'inverse, l'invention permet que le principal mouvement soit une translation et non plus, de manière nécessaire, un mouvement de rotation (autour d'un axe identifiable), auquel cas, la trajectoire de défilement étant rectiligne, on dispose les cames sur ce support en sorte d'aligner leurs longueurs parallèlement les unes aux autres en étant à une même distance de cette trajectoire de défilement. De manière encore plus générale, la trajectoire peut être une combinaison de portions rectilignes et de portions circulaires.

En outre, l'invention permet que la source puisse ne plus être nécessairement horizontalement en regard des cames ; c'est ainsi que les cames peuvent défiler horizontalement au-dessus ou en dessous de la source, voire selon une autre direction devant la source.

On peut noter que, par rapport à un document tel que DE - 10 2009 053 046, l'invention se distingue par le fait que, bien que ce document mentionne le fait de former un revêtement de DLC sur une partie seulement de cames, il n'y est ni décrit ni suggéré de revêtir sélectivement le nez des cames, voire une fraction seulement de celui-ci. On comprend dans ce document que cette partie revêtue peut se limiter à la zone de glissement, c'est-à-dire la totalité de la tranche des cames ; en effet, il est expliqué que l'obtention du revêtement se fait en disposant les pièces sur un mandrin qui est ensuite placé dans un four, les pièces étant disposées de manière adjacente de sorte que le revêtement ne se forme que sur la surface de glissement ou la surface extérieure de ces cames (il est recommandé que l'évidement central des cames ne soit pas, lui, revêtu) ; ce document ne décrit ni ne suggère de former le revêtement sur au plus le nez des cames, voire sur une fraction seulement de celui-ci ; en tout cas, il ne décrit ni ne suggère comment obtenir un tel résultat.

De même, par rapport à un document tel que EP - 2 682 230, l'invention se distingue par le fait que, bien que ce document mentionne le fait que des cames puissent ne comporter un revêtement de carbone amorphe que sur des zones de leurs surfaces, ce document ne décrit ni ne suggère de limiter un tel revêtement sur le nez, voire seulement une fraction de ce nez. En fait, ce document porte sur la formation d'une microstructure à la surface de la came, pour pouvoir piéger du lubrifiant, et ce n'est que par une généralisation sans la moindre information concrète qu'il est mentionné que le revêtement ainsi modifié peut être lui aussi limité à des zones de la came. Ce document ne décrit ni ne suggère de revêtir une seule zone des cames (tout ou partie du nez) et ne contient aucune information précise pour obtenir un tel résultat.

De manière préférée, les cames ayant un évidement central, on les dispose, dans le cas d'un mouvement de rotation, sur un carrousel en faisant traverser les évidements par des tiges positionnées parallèlement à l'axe du carrousel et disposées à une même distance de cet axe, ces tiges étant réparties angulairement de manière régulière autour de cet axe en sorte que les cames engagées sur une tige soient au moins approximativement au contact avec les cames engagées sur les tiges les plus proches ; plus généralement, on dispose les tiges parallèlement les unes aux autres à une même distance de la trajectoire de défilement en sorte d'être orientées perpendiculairement à la direction d'émission de la source de revêtement lorsqu'elles viennent en regard de celle-ci, en étant réparties de manière régulière le long de celle-ci en sorte que les cames engagées sur une tige soient au moins approximativement au contact avec les cames engagées sur les tiges les plus proches,. En pratique on peut estimer que les cames sont au moins approximativement au contact avec les cames engagées sur une tige voisine lorsque l'espace entre ces cames ne dépasse pas 20%, voire 10% de leur diamètre. On peut apprécier que cela permet un positionnement précis et dense des cames sur un support tel qu'un plateau ou un carrousel.

De manière préférée, on dispose sur le carrousel des caches, tous disposés à une même distance vis-à-vis de l'axe du carrousel qui est supérieure ou égale à celle à laquelle les tiges sont situées par rapport à cet axe en alternant circonférentiellement avec ces tiges, de manière à masquer, vis-à-vis de la (ou des) source(s) de dépôt, les zones des cames où leurs tranches sont en regard des cames voisines ; plus généralement, on dispose les caches à une même distance vis-à-vis d'une surface définie par l'ensemble des tiges lors de leur mouvement relatif par rapport à la source, en alternant avec ces tiges, en sorte d'être en avant de ces tiges en direction de la source lorsque les tiges et les cames qu'elles servent à positionner viennent en regard de la source, de manière à masquer, vis-à-vis de la source, les zones des cames où leurs tranches sont en regard des cames voisines. On peut noter que la présence de tels caches permet de délimiter de manière précise les zones revêtues. On comprend que les caches ne peuvent être situées dans la surface définie par les tiges lors de leur mouvement que si les cames montées sur ces tiges ne sont pas circonférentiellement en contact avec les cames voisines (en d'autres termes, les cames ne sont dans ce cas qu'approximativement en contact).

De manière préférée, les caches ont, circonférentiellement ou parallélement à la surface définie par les tiges lors de leur mouvement, une dimension s'étendant depuis la surface des cames engagées sur une tige jusqu'à la surface des cames engagées sur une tige voisine, à un jeu près ; cette précision contribue à optimiser la précision avec laquelle la zone revêtue de chaque came est délimitée.

De manière préférée, dans le cas d'un support formé par un carrousel en rotation, la distance à l'axe de rotation des caches vaut entre 100% et 150% de la distance de l'axe des tiges vis-à-vis à cet axe de rotation ; cela délimite des fractions de la surface du nez qui sont suffisamment importantes pour contenir les zones où la came est en appui important sur la pièce antagoniste, mais suffisamment faibles pour pouvoir être obtenues facilement. De manière avantageuse, cette distance à l'axe des caches vaut de 110% à 130% de cette distance à l'axe des tiges.

De manière préférée, on dépose le revêtement à base de carbone avec une composition contenant de 20 à 50% atomique d'hydrogène, préférentiellement de 20% à 30% atomique d'hydrogène ; en effet, il est avantageux que le revêtement DLC contienne de l'hydrogène, ce qui apporte l'avantage que le revêtement formé présente une faible rugosité ; en effet, les dépôts de carbone sans hydrogène sont en pratique obtenus par une technologie d'arc et peuvent en conséquence présenter une rugosité importante à l'issue du dépôt, et il est nécessaire dans certains cas de les soumettre à une action de repolissage post revêtement, ce qui ne peut pas être économiquement intéressant. En pratique, les couches en carbone amorphe non hydrogéné présentent une bonne tenue en usure abrasive ; toutefois, les couches en carbone amorphe hydrogéné a-C:H, dont la tenue en usure abrasive est un peu moins bonne présentent moins de limitation en épaisseur.

De manière préférée, on forme, avant de déposer le revêtement à base de carbone, une sous-couche en carbure ou nitrure de tungstène, en carbure ou nitrure de chrome ou en un mélange de carbures et/ou nitrures de tungstène et de chrome , ou toute autre couche ou combinaison de couches connues de l'homme de l'art pour faire adhérer un revêtement DLC sur un substrat métallique. C'est en pratique un cas fréquent, puisqu'il est connu qu'une couche de DLC présente en soi une adhérence faible vis-à-vis d'un grand nombre de substrats, auquel cas la présence d'une couche d'accrochage est nécessaire.

De manière avantageuse, on forme, avant ou après l'application du revêtement DLC, une microtexturation en surface de tout ou partie de la surface du nez des cames ; cela permet d'optimiser la lubrification, en permettant en particulier de réduire le temps nécessaire pour atteindre le régime élasto-hydrodynamique de l'ensemble des cames et des pièces antagonistes, c'est-à-dire le comportement normal en service continu.

L'invention vise également une came obtenue par le procédé précité, c'est-à-dire une came dont seule une partie de la tranche, sur au plus le nez de cette came, est munie d'un revêtement à base de carbone amorphe DLC.

Par analogie, l'invention couvre un arbre comportant des cames obtenues par le procédé précité, c'est à dire un arbre à cames comportant des cames dont seule une partie de la tranche, représentant au plus le nez ce ces cames, est munie d'un revêtement à base de carbone amorphe Diamond Like Carbon ; c'est dans une telle configuration que l'invention prend toute son efficacité.

De manière préférée, les tranches des cames ne sont munies dudit revêtement que jusqu'à une distance, vis-à-vis des extrémités de la zone circulaire de ces cames, qui vaut au moins 20%, voire 30%, du rayon de cette zone circulaire de ces cames ; cela contribue à obtenir que le revêtement ne soit présent, sur une épaisseur significative, que sur une zone de la tranche des cames, où il est vraiment utile.

De manière avantageuse, ces cames présentent une microtexturation dans tout ou partie de la zone de la tranche munie dudit revêtement.

Par analogie, l'invention couvre un ensemble de motorisation comportant un arbre à cames du type précité et une pluralité de poussoirs (ou linguets) coopérant respectivement avec ces cames, chacun de ces poussoirs (ou linguets) ayant une surface de contact munie d'un revêtement à base de carbone Diamond Like Carbon; on comprend que c'est en service qu'un arbre dont les cames ont été traitées par le procédé précité prend son utilité.

Selon un autre aspect, l'invention propose l'utilisation d'un arbre à cames du type précité avec une pluralité de poussoirs (ou linguets) coopérant respectivement avec ces cames, chacun de ces poussoirs (ou linguets) ayant une surface de contact munie d'un revêtement à base de carbone Diamond Like Carbon, en présence d'une huile contenant des additifs de réduction de frottement à base de soufre et de molybdène, notamment des composés MoDTC ; cela revient à exprimer les conditions dans lesquelles l'invention surmonte les inconvénients d'une absence totale de revêtement sur la came.

Selon un autre aspect, l'invention propose une installation de traitement par revêtement pour la mise en œuvre du procédé précité, comportant une source de dépôt sous vide d'un matériau de revêtement, un carrousel adapté à tourner autour d'un axe de rotation en sorte de présenter sa périphérie en regard de cette source, ce carrousel comportant une pluralité de tiges parallèles à son axe, ces tiges étant fixes par rapport à ce carrousel en étant distribuées de manière régulière autour de l'axe à une même distance de cet axe en présentant un écartement angulaire propre à permettre que des cames d'un format prédéterminé puissent être engagées sur ces tiges en étant orientées radialement en ayant leurs nez pointant vers l'extérieur du carrousel ; cela revient à exprimer l'invention en termes de moyens pour la mise en œuvre du procédé précité.

Dans le cas général, cette installation peut être définie comme comportant une source de dépôt sous vide d'un matériau de revêtement, et un support adapté à être déplacé devant cette source suivant une trajectoire de défilement relatif, ce support comportant une pluralité de tiges parallèles entre elles, fixes par rapport à ce plateau en étant distribuées de manière régulière à une même distance de la trajectoire de défilement en sorte d'être orientées perpendiculairement à la direction d'émission de la source de matériau de revêtement lorsqu'elles viennent en regard de celle-ci, l'installation comportant en outre des cames ayant un évidement central, une tranche présentant une zone circulaire et une portion allongée formant un nez en ayant une longueur définie par la dimension maximale mesurée depuis leur nez jusqu'à la zone circulaire, les cames étant disposées sur le support selon une configuration fixe et dense en faisant traverser les évidements par les tiges, et ces tiges présentant un écartement entre elles tel que des cames d'un format prédéterminé engagées sur ces tiges sont au moins approximativement au contact avec les cames engagées sur les tiges les plus proches en étant orientées selon une même configuration par rapport à la trajectoire de défilement en ayant leurs nez orientés vers la source lorsqu'elles viennent en regard de cette source, en sorte de déposer un revêtement sélectivement sur les fractions des tranches des cames qui sont orientées vers ladite source, sur au plus le nez de ces cames.

Des objets, caractéristiques et avantages de l'invention ressortent de la description qui suit, donnée en regard des dessins annexés à titre illustratif non limitatif, sur lesquels :
- La figure 1 est une vue en perspective d'un arbre à cames conforme à l'invention,
- La figure 2 est un schéma de principe du procédé de revêtement des cames avant leur assemblage au sein d'un arbre à cames tel que celui de la figure 1,
- La figure 3 est un schéma de principe, en perspective, d'un carrousel adapté à la mise en œuvre du procédé de la figure 2,
- La figure 4 est un schéma de principe d'une installation de traitement comportant un carrousel tel que celui de la figure 3,
- La figure 5 est un schéma du contour d'une came telle que celles des figures précédentes,
- La figure 6 est un schéma de principe d'une variante de réalisation d'un carrousel adapté à la mise en œuvre du procédé de l'invention,
- La figure 7 est un graphique corrélant le volume d'usure en fonction du temps, pour des revêtements obtenus en double ou en triple rotation,
- La figure 8 est un graphique corrélant le taux d'usure à la nature des matériaux présents, en surface, sur deux pièces antagonistes du type came/poussoir,
- La figure 9 est un graphique corrélant le coefficient de frottement à la vitesse de mouvement relatif, pour deux couples de matériaux présents, en surface, sur deux pièces antagonistes,
- La figure 10 est un graphique corrélant le coefficient de frottement au rapport vitesse/pression, pour les deux couples de matériaux présents, en surface, sur les deux pièces antagonistes de la figure 9, et
- La figure 11 est un schéma de principe du procédé de revêtement des cames (avant leur assemblage au sein d'un arbre à cames), selon une variante de la figure 2 dans laquelle le mouvement est une translation.

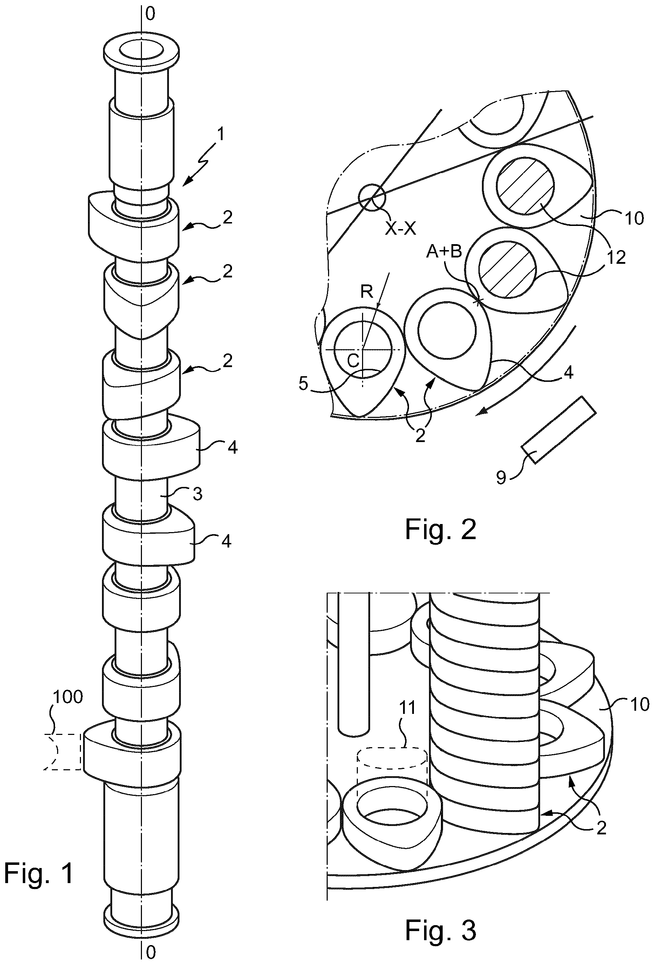

La figure 1 représente un arbre à cames, désigné par la référence 1, formé de l'assemblage d'une pluralité de cames 2 engagées sur un arbre commun 3, chaque came présentant par rapport à une came voisine un décalage angulaire défini en fonction du type de moteur à combustion interne avec lequel cet arbre à cames est destiné à coopérer.

Conformément à l'invention, seule une partie 4 des cames est munie d'un revêtement protecteur à base de carbone amorphe, appelé DLC (« Diamond-like Carbon ») avantageusement chargé en hydrogène. Cette partie 4 correspond à tout ou partie de la portion habituellement appelée « nez de came », c'est-à-dire la partie allongée de la came, par opposition au reste de la came, parfois appelé « partie arrière de la came », qui présente, par rapport à l'axe de l'arbre, une distance minimale en pratique constante : en effet, le contour de cette partie arrière est classiquement une portion de cylindre.

En fait, chaque came 2 comporte un évidement central cylindrique 5 (voir la figure 2) dont le centre C est destiné à être situé sur l'axe O-O de l'arbre ; c'est par rapport à ce centre que la portion arrière est une portion de cylindre (ou zone circulaire) de rayon noté R. Cette zone circulaire s'étend sur un angle de 180° autour de cet axe.

Sur cette figure 1 est représenté, en ligne fantôme, l'un des poussoirs 100 avec lequel l'arbre à cames est destiné à coopérer en service.

La figure 2 représente, de manière schématique, le procédé par lequel les cames 2 sont munies, en leur zone 4 seulement, d'un revêtement protecteur de type DLC.

Ces cames 2 sont individuellement traitées par présentation de cette zone 4 à une source de dépôt sous vide d'un matériau de revêtement schématisée sous la référence 9, de tout type connu approprié, en pratique une source de carbone au sein d'une installation de dépôt physique en phase vapeur (« PVD » en abrégé), avantageusement assistée par plasma (« plasma enhanced PVD ou PEPVD») ; un tel dépôt peut aussi être formé par dépôt chimique en phase vapeur (« CVD » ou, en cas d'assistance par plasma « PECVD »). Par simplification, l'enceinte adaptée à être mise sous vide pour un tel dépôt, n'est pas représentée.

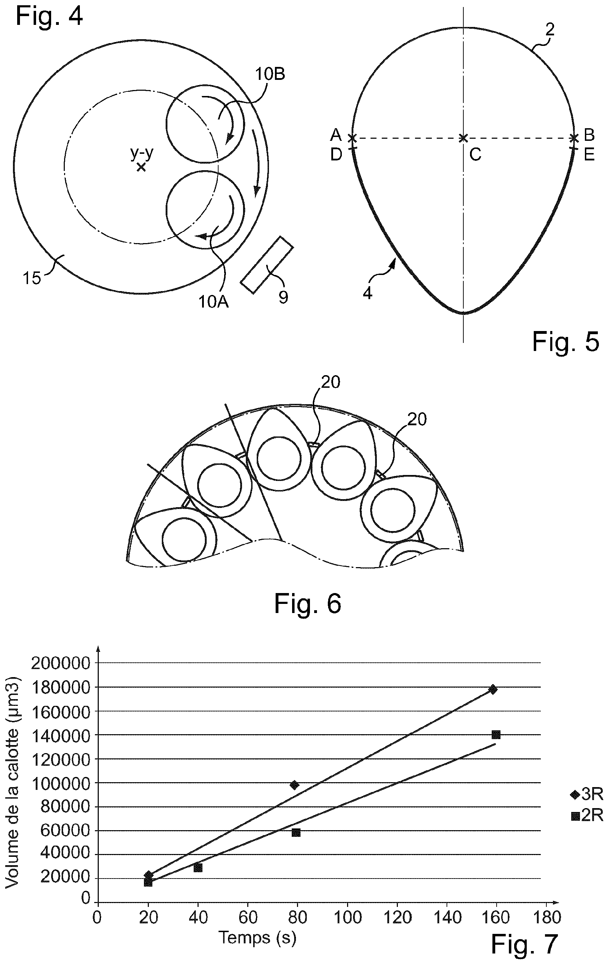

Pour permettre le traitement simultané d'un grand nombre de cames, ces cames sont en pratique montées sur un carrousel 10 adapté à être mis en rotation devant la source 9, autour d'un axe noté X-X. Il importe toutefois de noter que, puisque ces cames ne sont pas destinées à être revêtues sur toute leur surface, elles n'ont aucune sorte de mouvement de rotation par rapport au carrousel ; cela explique que, contrairement au cas où ces cames devraient tourner par rapport à leur carrousel, en un mouvement planétaire, les cames peuvent, selon l'invention, être disposées côte à côte. En effet, ainsi que cela sera commenté ci-dessous à propos de la figure 5, il n'est pas utile de déposer le revêtement protecteur au-delà des zones où des cames disposées côte à côte viennent en contact.

On comprend que la configuration de la figure 2 où des cames sont disposées côte à côte en étant en contact les unes avec les zones correspond à une configuration de densité maximale, c'est-à-dire une configuration permettant de disposer un nombre maximal de cames sur un carrousel donné pour que ces cames aient toutes un traitement identique de revêtement. Toutefois il peut, dans certains cas, être souhaité une configuration moins dense, avec un écartement entre des cames voisines, sans sortir du cadre de l'invention.

Le positionnement des cames sur le carrousel est en pratique assuré par une pluralité de tiges (ou noyaux) 12 parallèles à l'axe X-X en étant situées à une même distance vis-à-vis de cet axe X-X Ces tiges ont la même forme et la même section que les évidements circulaires prévus au sein des cames, avec un faible jeu, ce qui contribue à leur bon positionnement angulaire. On comprend que le fait de disposer les cames en contact les unes avec les autres contribue aussi au maintien de leur positionnement angulaire.

Non seulement des cames peuvent être disposées côte à côte le long de la périphérie d'un carrousel, mais elles peuvent en outre être empilées, ainsi que cela ressort de la figure 3.

On comprend que le nombre de cames disposées en un plan transversal à l'axe de rotation, et le nombre de cames dans chaque empilement peut être librement choisi en fonction des besoins et de l'espace disponible.

La figure 2 correspond à un cas particulièrement simple, où il y a un seul carrousel tournant autour de son axe. Mais ce cas n'est pas industriellement réaliste d'un point de vue économique ; en effet, conformément à la pratique habituelle dans le domaine des dépôts sous vide sur des pièces en lots, il y a une pluralité de carrousels identiques au carrousel 10, dont deux sont notés 10A et 10B à la figure 4 ; les carrousels sont montés sur un plateau général noté 15, monté rotatif autour d'un axe Y-Y, parallèle aux axes de rotation des carrousels. De la sorte toutes les cames montées sur les divers carrousels portés par le plateau viennent à leur tour en regard de la source 9 et peuvent en conséquence subir un même revêtement.

Toutes les cames ont en pratique la même composition et la même géométrie.

La figure 5 représente le contour d'une came 2. Le centre C est représenté, mais pas l'évidement central. La partie dite arrière, à paroi cylindrique, c'est-à-dire à contour circulaire, est délimitée par des points notés A et B qui sont diamétralement opposés. C'est en pratique en ces points que cette came vient en contact avec les cames adjacentes dans la configuration des figures 2 et 3. La zone revêtue 4 s'étend préférentiellement « en amont » de ces points A et B, c'est-à-dire plus près de l'extrémité du nez que ces points. Il est même apparu que la zone revêtue peut s'arrêter en des points D et E situés à une distance non nulle de ces points A et B (cela sera commenté plus loin).

La figure 6 représente, de manière partielle, une configuration permettant de bien maîtriser l'emplacement des extrémités de la zone revêtue sur les diverses cames ; cette maîtrise est obtenue en disposant des caches 20 entre les cames, empêchant que du matériau se dépose sur les cames à proximité des points A et B. On comprend que ces caches 20 sont disposés à une même distance de l'axe X-X du carrousel.

Il est apparu qu'un tel contrôle des extrémités de la zone revêtue permet d'obtenir, si cela paraît souhaitable, une épaisseur ne présentant pas de variation supérieure à 20% sur l'ensemble de la zone revêtue 4 ; cela peut notamment contribuer à éviter une perte d'adhérence de zones d'épaisseur trop faible.

L'épaisseur du revêtement est de l'ordre du micron, c'est-à-dire qu'elle est en pratique comprise entre 1 et 10 microns, préférentiellement 1 et 5 microns, ce qui permet de ranger ce revêtement dans la catégorie des couches minces ; c'est pourquoi de tels revêtements peuvent être formés par des techniques de dépôts en couches minces précitées, de type PVD ou PECVD, notamment.

De manière avantageuse, le procédé précité est complété, avant ou après le dépôt du revêtement précité, par une étape de microtexturation, c'est-à-dire par une étape dans laquelle on forme un relief, sur des profondeurs inférieures au micron (par exemple quelques dixièmes de micron), de manière à favoriser la dispersion d'un fluide de lubrification au-delà des cavités ainsi créées, et donc d'optimiser la lubrification ; cette microtexturation est effectuée sur tout ou partie de la surface du nez des cames, de préférence dans les zones de dépôt du revêtement. Cela permet, notamment, de décaler la transition entre régime élasto-hydrodynamique et régime mixte vers des conditions de fonctionnements plus sévères. Des modalités de formation d'une telle microtexturation sont notamment décrites dans le document WO - 2008/047062.

Il faut noter que le revêtement n'est pas obligatoirement présent sur la tranche des cames, en dehors de leurs nez, pas plus que sur leurs surfaces transversales à leur axe de translation (qui ne participent à aucun contact de frottement).

Le procédé décrit ci-dessus a été, à titre d'exemple, mis en œuvre sur des cames en acier au carbone faiblement allié, plus précisément en un acier 100C6 (1% de carbone et 1.5% Cr) ; bien entendu, l'invention peut s'appliquer à bien d'autres nuances d'acier, alliés ou non, sans limitation quant à leurs modalités d'obtention (elle s'applique ainsi, notamment, dans le domaine de la métallurgie des poudres ; bien entendu, le choix du matériau est fait en tenant compte du niveau de dureté souhaité pour l'application choisie et de sa compatibilité avec le procédé de revêtement. Celles-ci ont été traitées en utilisant la configuration des figures 2 et 3. Les modalités particulières indiquées ci-dessous ne sont mentionnées qu'à titre d'exemple, à propos de cames dont la partie arrière a un rayon de 16,50 mm (ce qui suffit pour définir, à partir des dessins, le reste de la géométrie de ces cames).

Plus précisément, après nettoyage des cames par tout procédé connu de l'homme de l'art, celles-ci ont été mise en place sur le carrousel de ces figures 2 et 3, certaines étant côte à côte en contact l'une avec l'autre, d'autres étant empilées. Le carrousel ainsi chargé en cames a été placé dans l'enceinte de traitement sous vide. Pendant le pompage pour obtenir le niveau de vide requis, un dégazage de l'enceinte, du carrousel et des cames a été obtenu par chauffage radiatif à une température de consigne choisie à un niveau inférieur de la température de revenu de ces diverses pièces (un tel choix est à la portée de l'homme de métier), ce qui permet d'éviter toute dégradation des propriétés mécaniques de l'acier.

Lorsque le vide a atteint une valeur satisfaisante, ici de 2.10⁻⁵ mbar, de l'argon a été introduit dans l'enceinte pour atteindre une pression de l'ordre de 10⁻³ mbar, et un décapage a été effectué selon des paramètres de décapage (puissance plasma, tension de bias) adaptés de manière à permettre l'élimination de la couche d'oxyde naturel présent sur les pièces, y compris dans les zones confinées au niveau du contact entre les cames. Il est à la portée de l'homme de métier d'adapter ces paramètres.

Après ce décapage, un dépôt de carbure de tungstène a été réalisé suivant un procédé de pulvérisation magnétron. En fin de dépôt PVD, la quantité de carbone dans la couche a été progressivement augmentée afin de créer une couche de transition ; un tel type de couche se désigne par WCC. Un dépôt de type carbone amorphe hydrogéné a enfin été réalisé par procédé PECVD.

La mention de cette sous-couche de WCC n'est faite qu'à titre d'exemple ; d'autres sous-couches peuvent aussi être utilisées pour une bonne adhérence du DLC, par exemple en CrN, ou Cr+WCC, notamment. La présence d'une telle sous-couche n'est qu'optionnelle, dépendant de la nature du matériau de la zone superficielle de la came.

Dans ces conditions on a obtenu un revêtement présentant une adhérence satisfaisante à partir d'une distance de 4mm par rapport au point de contact A ou B entre les deux cames. L'épaisseur mesurée de ce revêtement variait dans une fourchette d'à peine ± 20% à partir d'une distance de 8 mm par rapport à ce même point de contact. On a observé une absence totale de revêtement sur la partie arrière des cames, c'est-à-dire sur les parties dont les contours, tels que le contour AB de la figure 5, sont circulaires.

A titre d'exemple, des mesures d'adhérence et d'épaisseur ont été réalisées sur une came traitée comme indiqué ci-dessus, en différentes positions par rapport au point de contact A ou B ; ces positions sont calculées à partir de ces points A ou B, qui ont donc la cote de 0 mm.

Les tests d'adhérence sont réalisés suivant la norme VDI3198, les mesures d'épaisseur sont réalisées par Calotest.

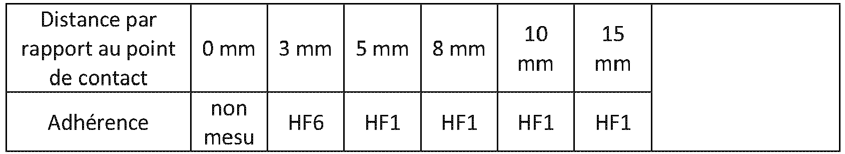

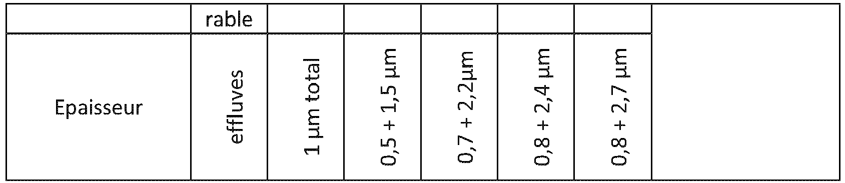

On constate qu'on ne trouve que des traces du revêtement au niveau des points A ou B, que le revêtement est d'à peine de l'ordre du micron à 3 mm de ces points, mais qu'on a une épaisseur significative à partir de 5 mm, laquelle atteint un maximum au-delà de 10 mm. En d'autres termes, le revêtement a une épaisseur voisine de l'ordre de 2-3 microns jusqu'à une distance de 5 mm des points de contact et s'étend, avec une épaisseur qui décroit rapidement il est vrai, jusqu'à 3 mm de ces points. Un revêtement satisfaisant en DLC a donc été obtenu, sur le nez de la came, en laissant à nu l'arrière de celle-ci, ce qui confirme l'efficacité du choix de n'avoir aucun mouvement des cames vis-à-vis du carrousel lors de la phase de revêtement. Pour être précis, le revêtement obtenu a été, dans l'exemple décrit ci-dessus, un revêtement conforme à la désignation commerciale Certess DDT, c'est-à-dire un DLC chargé en hydrogène (type a-C:H - voir le document WO - 2012/156746). Bien entendu, il ne s'agit ici que d'un exemple de revêtement possible ; la présence d'hydrogène n'est pas indispensable ; par ailleurs, lorsqu'il est présent, la concentration de l'hydrogène peut être choisie en fonction des besoins.

Il appartient à l'homme de métier d'optimiser, en fonction des besoins particuliers et des matériaux sous-jacents, le montage des pièces, les paramètres du décapage puis ceux du dépôt.

Selon un autre exemple, des cames en acier de diamètre externe de 33 mm (dans la partie arrière) et de longueur 41.6 mm (soit identiques à celles du premier exemple) ont été recouvertes d'un revêtement de DLC, en utilisant la configuration de la figure 6, avec des caches 20 situées environ à 5 mm des points de contact A et B ; cela a permis l'obtention d'un revêtement s'arrêtant de manière nette, sensiblement dans le prolongement des caches.

Les cames avaient suivi la même procédure (nettoyage, mise sous vide, dégazage, décapage et dépôt) que dans le premier exemple. On a pu vérifier que le revêtement ainsi obtenu présentait une épaisseur ne variant pas de plus de 20% sur la surface exposée à la source de matériau de revêtement (le reste de la tranche des cames étant dépourvu de tout revêtement).

Il se confirme ainsi que l'ajout d'une pièce additionnelle pour définir l'arrêt de la zone revêtue permet d'avoir un revêtement adhérent et d'épaisseur uniforme sur toute la zone concernée par le revêtement DLC. Il est à la portée de l'homme de métier d'ajuster la position des caches en fonction des besoins, par rapport à la distance à l'axe du carrousel des points A et B.

Le gain en taux de remplissage d'une installation donnée de dépôt d'un revêtement de DLC peut être bien compris en notant que, dans un équipement de dépôt industriel désigné sous la référence TSD 850 construit par la société HEF Durferrit, on a pu obtenir un gain de l'ordre de 30% à 50% sur ce taux de remplissage. Dans cette comparaison les pièces ont eu les dimensions déjà considérées (diamètre de 33mm, longueur de 41.60 mm et épaisseur de 9.3 mm).

Par ailleurs, par rapport à l'obtention d'un revêtement de 3 microns sur la totalité de la surface externe des cames, au moyen d'une telle machine TSD 850 avec la rotation des cames par rapport aux carrousels, l'obtention d'un même revêtement limité à tout ou partie du nez de ces cames (sans rotation des cames par rapport aux carrousels) a pu se faire avec une réduction du temps de cycle de l'ordre de 35%.

La figure 7 visualise l'amélioration apportée par l'invention en termes de vitesse d'usure ; elle présente les résultats d'un test d'usure par « Calotest » effectué sur deux types de pièces revêtues avec un DLC chargé en hydrogène. Ces pièces ont été respectivement : revêtues sur toute leur surface latérale (360° avec une triple rotation) - désignés par le sigle 3R - et revêtues sur une fraction angulaire de leur superficie (du fait de l'absence de rotation par rapport au carrousel porteur) - désignés par le sigle 2R.

On constate sur la figure 7 que la pièce revêtue en double rotation conformément à l'invention présente une vitesse d'usure moindre que celle revêtue sur toute sa surface latérale.

Des essais de microdureté ont été effectués sur des pièces cylindriques munies du revêtement précité appliqué en triple rotation (3R), ou en double rotation, conformément à l'invention (2R). Les résultats sont reportés dans le tableau ci-dessous.

| | | H_{IT} (Gpa) | HV0,02 | E* (Gpa) |
|---|---|---|---|---|
| 2R | Diam 28 | 29,7 | 2756 | 263,2 |
| | Diam 20 | 27 | 2501 | 243,4 |
| 3R | Diam 24 | 27,3 | 2533 | 211,1 |
| | Diam 18 | 25,1 | 2326 | 214,2 |

On constate que pour des diamètres comparables, les caractéristiques du revêtement élaboré en configuration double rotation sont supérieures à celles du revêtement élaboré en configuration triple rotation. Ces informations corrèlent avec les résultats du test d'usure. Il faut comprendre que la gamme des diamètres mentionnés dans le tableau ci-dessous n'a rien de limitatif et que l'invention peut s'appliquer à des pièces plus petites ou au contraire plus grandes.

Sous l'angle de la dureté, on peut dire que, lorsque l'on est en configuration triple rotation, la dureté (et donc la résistance à l'usure par abrasion) du revêtement effectué a tendance à diminuer. Cette diminution peut être compensée par un ajustement des paramètres de dépôt, mais uniquement jusqu'à un certain point. En effet, l'ajustement de ces paramètres se traduit par une augmentation de la température atteinte par les pièces lors du revêtement. Or ces pièces mécaniques sont très largement issues d'aciers cémentés, qui ne supportent pas les températures trop élevées. De manière générale, il semble recommandé d'effectuer le dépôt à une température inférieure à 220°C, voire inférieure à 200°C.

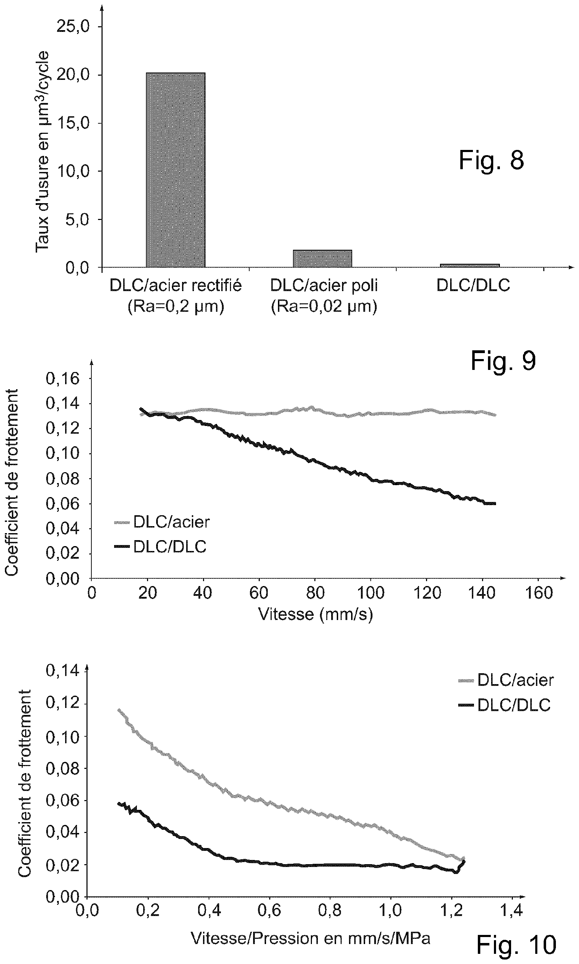

L'efficacité de l'invention pour minimiser la dégradation du revêtement de DLC en présence d'huiles contenant des MoDTC ressort de la figure 8 où sont reportées les taux d'usure constatés dans des tests de frottement bille/plan dans une huile contenant des MoDTC, pour trois couples de matériaux en contact de frottement, avec les paramètres suivants :
- Charge appliquée : 10N
- Vitesse linéaire de déplacement : 35mm/s
- Mode : excentrique
- Nombre de cycles : 15000
- Rayon de la sphère : 5 mm
- Déplacement : 10 mm
- Température de l'huile : 110°C
- Nature de la bille : acier et revêtue DLC

On constate que, avec un couple de deux pièces comportant chacune un revêtement de DLC, on a un taux d'usure qui est près de 70 fois inférieur à celui obtenu en cas de couple bille revêtue DLC/acier rectifié (ce qui correspond à la configuration classique d'un poussoir revêtu combiné avec une came en acier).

Enfin les figures 9 et 10 visualisent l'intérêt de l'invention en termes de diminution du coefficient de frottement, à partir d'essais de frottement en configuration cylindre/plan avec les paramètres suivants :
- Le cylindre et le plan étant polis (Ra = 0,02µm),
- Après une phase de rodage de 18 000 cycles,
- Sous une charge constante de 21N.

Au démarrage du test, pendant la phase de rodage, on est en régime de lubrification limite, les coefficients de frottement sont identiques dans le cas d'un frottement acier revêtu DCL/acier et pour un frottement acier revêtu DLC/ acier revêtu DLC. A la fin du rodage, on constate que le couple acier revêtu DLC/acier présente un coefficient de frottement constant quelle que soit la vitesse, indiquant que l'on est toujours en régime de lubrification limite.

Le couple acier revêtu DLC/acier revêtu DLC présente le même coefficient de frottement pour des vitesses inférieures à 35 mm/s. Au-delà de cette vitesse, le coefficient de frottement diminue lorsque la vitesse augmente, indiquant le passage en régime de lubrification mixte.

Le couple acier revêtu DLC/ acier revêtu DLC, en conditions de fonctionnement identiques, présente des coefficients de frottement plus faible, beaucoup plus rapidement.

Une fois le régime mixte atteint (rapport vitesse/charge plus important), le couple acier revêtu DLC/ acier revêtu DLC présente des valeurs de coefficient de frottement plus faible que le couple DLC/acier (voir la figure 10).

On appréciera que l'invention permet un gain économique dans la réalisation du revêtement DLC sur la came. Par ailleurs, le fait d'appliquer le revêtement de manière partielle sur la came, permet d'augmenter l'épaisseur dudit revêtement, tout en conservant ses bonnes propriétés mécaniques, et en restant intéressant d'un point de vue économique.

Par un effet surprenant, le dépôt réalisé dans cette configuration (double rotation) présente de meilleures propriétés que le dépôt intégral réalisé dans une configuration triple rotation.

Cette solution montre dans le cas des contacts acier revêtu DLC/ acier revêtu DLC des diminutions importantes du frottement et de l'usure des composants revêtus (came/linguet ou came/poussoir). Elle permet par ailleurs d'éviter toute dégradation accélérée du revêtement DLC induite par l'utilisation d'huiles additivées, contenant notamment des composés de type MoDTC.

Dans le cas où le contact présenterait une lubrification limite, le maintien de l'huile dans la zone la plus sollicitée du contact est assuré par la différence de mouillabilité entre les zones revêtues et non revêtue.

Dans le cas des contacts came/linguet, il est couramment utilisé des linguets à rouleau, qui imposent des lois de cames peu sévères. Cette solution permet de supporter les lois de cames plus sévères appliquées pour les linguets à patin, tout en conservant des pertes par frottement faibles. Le transfert vers la technologie des linguets à patin apportant par ailleurs des gains de consommation de carburant, du fait de la diminution de poids du système et de loi de came proprement dite.

Le bord de chacun des carrousels constitue une ligne de référence pour ce carrousel, et, dans la configuration de la figure 2 (avec un seul carrousel ayant un axe fixe) ainsi que dans la configuration de la figure 4 (avec plusieurs carrousels ayant des axes de rotation portés par un plateau tournant), on peut admettre que les cames qui sont juste en regard de la source de matériau de revêtement ont une trajectoire qui est parallèle (concentrique) à cette ligne de référence.

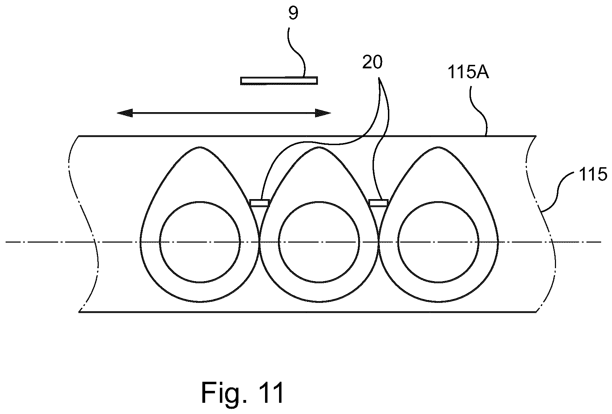

Il est important de noter qu'un cas limite de l'invention, lorsqu'on repousse le centre de rotation à l'infini, correspond à un mouvement de translation. La figure 11 est une variante de la configuration représentée ci-dessus par les figures 2 et 4 montrant des cames montées sur un plateau 115, parallèlement à une ligne droite de référence constituée par le bord 115A du plateau ; ce plateau est animé d'un mouvement de translation devant la source de matériau de revêtement (désignée par la même référence 9 qu'à la figure 2) ; ce mouvement, selon la trajectoire matérialisée par la flèche F, peut être strictement rectiligne ou présenter une légère courbure, en fonction de l'espace disponible. Le mouvement de translation peut être un mouvement continu ou alternatif ; l'intérêt d'un mouvement alternatif est de permettre que chaque came passe plusieurs fois devant la source de matériau de revêtement ; on comprend toutefois que, sous réserve que la trajectoire au moins approximativement rectiligne du plateau se raccorde, à distance de la source, à des portions de trajectoire semi-circulaires, le plateau peut suivre une boucle aplatie, en un mouvement continu.

Dans cette configuration à mouvement de translation, il peut n'y avoir qu'un seul plateau portant l'ensemble des cames à traiter, et non pas deux supports comme dans le cas de la figure 4.

Des caches 20 peuvent ici aussi être prévus pour bien délimiter la fraction des tranches des cames qui est recouverte.

Dans les exemples représentés, les bords ont une forme géométrique simple, circulaire dans le cas de la figure 2 (centrée sur l'axe de rotation du carrousel) ou rectiligne dans le cas de la figure 11 ; en fonction des besoins, on peut prévoir que ce bord présente des ondulations dans son plan, par exemple pour minimiser la matière entre des tiges adjacentes. Dans un tel cas la ligne de référence peut être définie par la ligne géométrique la plus simple qui longe un tel bord.

Selon encore une autre variante (non représentée), la source de matériau de revêtement 9 est disposée, non pas latéralement (c'est-à-dire horizontalement) en regard du support des cames, mais au-dessus de celui-ci ; ainsi, les cames peuvent être engagées sur des tiges horizontales, parallèles au plateau qui leur sert de support, en ayant leurs nez pointant vers le haut.

A l'inverse, la source peut être disposée en dessous des cames, les cames étant engagées sur des tiges situées sous le plateau, dans une orientation dans laquelle, par simple gravité, leurs nez pointent vers le bas.

Selon encore une autre variante, les tiges peuvent être disposées selon une direction inclinée, sous réserve que les cames soient disposées sur le support selon une configuration fixe définie, conjointement avec la trajectoire de défilement, de telle manière que les cames sont amenées successivement en regard de la source de revêtement avec des orientations sensiblement identiques et à des distances sensiblement identiques par rapport à cette source, en sorte de déposer un revêtement sélectivement sur les fractions des tranches des cames qui sont orientées vers ladite source.

Là encore, les cames peuvent être associés à des caches comme précédemment.

Selon encore une autre variante, le carrousel des figures 2 ou 4 peut être orienté en sorte de tourner autour d'un axe non vertical, horizontal ou incliné d'un angle non nul par rapport à l'horizontale et à la verticale.

Les orientations et les distances ci-dessus peuvent n'être que « sensiblement » identiques en ce sens que, si la source n'a pas la même dimension, transversalement à la trajectoire de défilement, que la pluralité de cames, les cames situées à la périphérie de la pluralité peuvent recevoir du matériau de revêtement selon des orientations légèrement différentes que pour les cames disposés au milieu de la pluralité, et peuvent être à des distances légèrement plus importantes que les cames situées en position centrale. En pratique ces orientations sont identiques à au plus 5° près et les distances sont identiques à au plus 5% près.

Dans ce qui précède, le mouvement entre les cames et la source est relatif en ce sens que, alors que dans les exemples décrits les cames se déplacent par rapport à une source fixe, l'invention couvre également le cas d'une source en mouvement par rapport à une pluralité de cames fixes.

De manière générale, on peut noter que l'invention permet de revêtir, de manière sélective et contrôlée, une partie seulement de la tranche de cames (le revêtement est présent là où on le souhaite mais pas là où on n'en a pas besoin), d'une manière suffisamment simple pour ne pas induire de surcoût significatif, par rapport à une technique classique de revêtement à 100%, et permettre ainsi de tirer profit de la réduction de la quantité de matière de revêtement. En outre, aucune finition n'est nécessaire avant que les cames soient mises en service.

## Revendications

1. Procédé de traitement des cames d'un arbre à cames pour véhicule à combustion interne pour en réduire le frottement vis-à-vis d'une pièce antagoniste en une zone munie d'un revêtement dur à base de carbone amorphe du type Diamond Like Carbon ou DLC, ces cames ayant un évidement central, une tranche présentant une zone circulaire et une portion allongée formant un nez en ayant une longueur définie par la dimension maximale mesurée depuis leur nez jusqu'à la zone circulaire, procédé selon lequel on dispose les cames sur un support, on amène ce support dans une enceinte que l'on met sous vide en sorte d'assurer un décapage des cames, on met ce support en mouvement relatif suivant une trajectoire de défilement par rapport à une source de dépôt sous vide d'un matériau de revêtement dur à base de carbone amorphe de type Diamond Like Carbon ou DLC et on enlève ces cames vis-à-vis du support avant de les assembler au sein d'un arbre à cames, **caractérisé en ce que**, le support comportant une pluralité de tiges parallèles entre elles, fixes par rapport à ce support et distribuées de manière régulière à une même distance de la trajectoire de défilement en étant orientées perpendiculairement à la direction d'émission de la source de matériau de revêtement lorsqu'elles viennent en regard de cette source, on dispose les cames sur le support selon une configuration fixe et dense en faisant traverser les évidements par les tiges, les tiges étant réparties de manière régulière le long de cette trajectoire en sorte que les cames engagées sur une tige soient au moins approximativement au contact avec les cames engagées sur les tiges les plus proches, les cames dans cette configuration fixe et dense sont amenées successivement, selon cette trajectoire de défilement, en regard de la source de revêtement avec des orientations sensiblement identiques et à des distances sensiblement identiques par rapport à cette source, en sorte de déposer un revêtement sélectivement sur les fractions des tranches des cames qui sont orientées vers ladite source, sur au plus le nez de ces cames.

2. Procédé selon la revendication 1 selon lequel, le support étant un carrousel ayant un axe de rotation, on dispose les cames sur le carrousel en sorte d'aligner leurs longueurs suivant des rayons de ce carrousel en étant à une même distance de l'axe de rotation, et le mouvement appliqué au carrousel est une rotation autour dudit axe.

3. Procédé selon la revendication 1 selon lequel, le support ayant une trajectoire de défilement rectiligne, on dispose les cames sur ce support en sorte d'aligner leurs longueurs parallèlement les unes aux autres en étant à une même distance de cette trajectoire de défilement.

4. Procédé selon l'une quelconque des revendications 1 à 3, selon lequel on dispose sur le support des caches, tous disposés à une même distance vis-à-vis d'une surface définie par l'ensemble des tiges lors de leurs mouvements relatifs par rapport à la source en alternant avec ces tiges, en sorte d'être en avant de ces tiges en direction de la source lorsque les tiges et les cames viennent en regard de la source, de manière à masquer, vis-à-vis de la source, les zones des cames où leurs tranches sont en regard des cames voisines.

5. Procédé selon l'une quelconque des revendications 1 à 4, selon lequel on dépose le revêtement à base de carbone avec une composition contenant de 20 à 50% atomique d'hydrogène.

6. Procédé selon l'une quelconque des revendications 1 à 5, selon lequel on forme, avant de déposer le revêtement à base de carbone, une sous-couche en carbure ou nitrure de tungstène, en carbure ou nitrure de chrome ou en un mélange de carbures et/ou nitrures de tungstène et de chrome.

7. Procédé selon l'une quelconque des revendications 1 à 6, selon lequel, avant ou après la formation du revêtement DLC, on forme une microtexturation en surface de tout ou partie du nez des cames.

8. Came obtenue par le procédé selon l'une quelconque des revendications 1 à 7, dont seule une partie de la tranche, représentant au plus le nez de cette came, est munie d'un revêtement à base de carbone amorphe Diamond Like Carbon.

9. Arbre à cames comportant des cames obtenues par le procédé selon l'une quelconque des revendications 1 à 7, dont seule une partie de la tranche, représentant au plus le nez ce ces cames, est munie d'un revêtement à base de carbone amorphe Diamond Like Carbon.

10. Arbre à cames selon la revendication 9, dont les tranches des cames ne sont munies dudit revêtement que jusqu'à une distance, vis-à-vis des extrémités de la zone circulaire des cames, qui vaut au moins 30% du rayon de cette zone circulaire de ces cames.

11. Ensemble de motorisation comportant un arbre à cames selon la revendication 9 ou 10 et une pluralité de poussoirs ou linguets coopérant respectivement avec ces cames, chacun de ces poussoirs ou linguets ayant une surface de contact munie d'un revêtement à base de carbone amorphe dur Diamond Like Carbon.

12. Utilisation d'un arbre à cames selon la revendication 9 ou 10 en combinaison avec une pluralité de poussoirs ou linguets coopérant respectivement avec ces cames, chacun de ces poussoirs ou linguets ayant une surface de contact munie d'un revêtement à base de carbone Diamond Like Carbon, en présence d'une huile contenant des additifs de réduction de frottement à base de soufre et de molybdène.

13. Installation de traitement par revêtement pour la mise en oeuvre du procédé de l'une quelconque des revendications 1 à 7, comportant une source de matériau de revêtement, et un support adapté à être déplacé devant cette source suivant une trajectoire de défilement relatif, ce support comportant une pluralité de tiges parallèles entre elles, ces tiges étant fixes par rapport à ce support en étant distribuées de manière régulière à une même distance de la trajectoire de défilement en sorte d'être orientées perpendiculairement à la direction d'émission de la source de matériau de revêtement lorsqu'elles viennent en regard de cette source, l'installation comportant en outre des cames ayant un évidement central, une tranche présentant une zone circulaire et une portion allongée formant un nez en ayant une longueur définie par la dimension maximale mesurée depuis leur nez jusqu'à la zone circulaire, les cames étant disposées sur le support selon une configuration fixe et dense en faisant traverser les évidements par les tiges, et ces tiges présentant un écartement entre elles tel que des cames d'un format prédéterminé engagées sur ces tiges sont au moins approximativement au contact avec les cames engagées sur les tiges les plus proches en étant orientées selon une même configuration par rapport à la trajectoire de défilement en ayant leurs nez orientés vers la source lorsqu'elles viennent en regard de cette source, en sorte de déposer un revêtement sélectivement sur les fractions des tranches des cames qui sont orientées vers ladite source, sur au plus le nez de ces cames.

14. Installation selon la revendication 13, dont le support est un carrousel adapté à tourner autour d'un axe de rotation devant ladite source.

## Patentansprüche

1. Verfahren zur Behandlung der Nocken einer Nockenwelle für ein Fahrzeug mit innerer Verbrennung, um deren Reibung gegenüber einem Gegenstück in einer Zone zu verringern, die mit einer auf amorphem Kohlenstoff basierenden harten Beschichtung vom Typ Diamond Like Carbon oder DLC versehen ist, wobei diese Nocken eine zentrale Aussparung sowie einen Rand mit einer Kreisfläche und einem länglichen Abschnitt aufweist, der eine Nase mit einer Länge bildet, die durch die maximale Abmessung, gemessen von seiner Nase zu der Kreisfläche, definiert ist, wobei bei dem Verfahren die Nocken auf einem Träger angeordnet werden, dieser Träger in ein Gehäuse eingebracht wird, das unter Vakuum gesetzt wird, so dass ein Reinigen der Nocken gewährleistet ist, dieser Träger in eine Relativbewegung entlang einer Laufbahn in Bezug auf eine Vakuumabscheidungsquelle eines auf amorphem Kohlenstoff basierenden harten Beschichtungsmaterials vom Typ Diamond Like Carbon oder DLC versetzt wird, und diese Nocken von dem Träger entfernt werden, bevor sie zu einer Nockenwelle zusammengebaut werden, **dadurch gekennzeichnet, dass** der Träger aus einer Vielzahl von zueinander parallelen Stäben besteht, die in Bezug auf diesen Träger fixiert und im gleichen Abstand von der Laufbahn gleichmäßig verteilt sind, wobei sie senkrecht zur Emissionsrichtung der Beschichtungsmaterialquelle ausgerichtet sind, wenn sie der Quelle zugewandt sind, die Nocken auf dem Träger in einer festen und dichten Konfiguration angeordnet werden, indem die Stäbe durch die Aussparungen geführt werden, wobei die Stäbe gleichmäßig entlang dieser Laufbahn verteilt sind, so dass die Nocken, die auf einem Stab in Eingriff sind, zumindest annähernd in Kontakt mit den Nocken stehen, die auf den nächstgelegenen Stäben in Eingriff sind, die Nocken in dieser festen und dichten Konfiguration nacheinander auf dieser Laufbahn gegenüber der Beschichtungsquelle mit im Wesentlichen identischen Ausrichtungen und in im Wesentlichen identischen Abständen von dieser Quelle gebracht werden, um selektiv eine Beschichtung auf den Bruchteilen der Nockenränder, die zu dieser Quelle hin ausgerichtet sind, auf höchstens der Nase dieser Nocken abzuscheiden.

2. Verfahren nach Anspruch 1, wobei, wenn der Träger ein Karussell mit einer Drehachse ist, die Nocken auf dem Karussell so angeordnet werden, dass ihre Längen entlang der Radien dieses Karussells ausgerichtet sind, während sie sich im gleichen Abstand von der Drehachse befinden, und die auf das Karussell ausgeübte Bewegung eine Drehung um diese Achse ist.

3. Verfahren nach Anspruch 1, wobei, wenn der Träger eine geradlinige Laufbahn hat, die Nocken auf diesem Träger so angeordnet werden, dass ihre Längen parallel zueinander in gleichem Abstand von dieser Laufbahn ausgerichtet werden.

4. Verfahren nach einem der Ansprüche 1 bis 3, wobei auf dem Träger Abdeckungen angeordnet werden, die alle im gleichen Abstand von einer Oberfläche, die durch die Gesamtheit der Stäbe während ihrer Relativbewegungen in Bezug auf die Quelle definiert ist, im Wechsel mit diesen Stäben so angeordnet werden, dass sie sich vor diesen Stäben zur Quelle hin befinden, wenn die Stäbe und die Nocken sich der Quelle zuwenden, so dass die Bereiche der Nocken, in denen ihrer Ränder den benachbarten Nocken gegenüberliegen, in Bezug auf die Quelle verdeckt werden.

5. Verfahren nach einem der Ansprüche 1 bis 4, wobei die auf Kohlenstoff basierende Beschichtung auf mit einer Zusammensetzung abgeschieden wird, die 20 bis 50 Atom-% Wasserstoff enthält.

6. Verfahren nach einem der Ansprüche 1 bis 5, wobei vor dem Aufbringen der auf Kohlenstoff basierenden Beschichtung eine Unterschicht aus Wolframkarbid oder -nitrid, Chromkarbid oder -nitrid oder einer Mischung aus Wolfram- und Chromkarbiden und/oder -nitriden gebildet wird.

7. Verfahren nach einem der Ansprüche 1 bis 6, wobei vor oder nach dem Bilden der DLC-Beschichtung eine Oberflächen-Mikrotexturierung der gesamten oder eines Teils der Nockennase gebildet wird.

8. Nocken, der durch das Verfahren nach einem der Ansprüche 1 bis 7 erhalten worden ist, von dem nur ein Teil des Randes, der höchstens die Nase dieses Nockens darstellt, mit einer auf amorphem Kohlenstoff basierenden Beschichtung Kohlenstoff Diamond Like Carbon versehen ist.

9. Nockenwelle, die Nocken umfasst, die durch das Verfahren nach einem der Ansprüche 1 bis 7 erhalten worden sind, von denen nur ein Teil des Randes, der höchstens die Nase dieser Nocken darstellt, mit einer auf amorphem Kohlenstoff basierenden Beschichtung Diamond Like Carbon versehen ist.

10. Nockenwelle nach Anspruch 9, deren Nockenränder nur bis zu einem Abstand von den Enden der Kreisfläche der Nocken, der mindestens 30% des Radius der Kreisfläche der Nocken beträgt, mit dieser Beschichtung versehen sind.

11. Motorisierungsbaugruppe, umfassend eine Nockenwelle nach Anspruch 9 oder 10 und eine Vielzahl von Stößeln oder Kipphebeln, die jeweils mit diesen Nocken zusammenwirken, wobei jeder dieser Stößel oder Kipphebel eine Kontaktfläche aufweist, die mit einer auf amorphem Kohlenstoff basierenden Beschichtung Diamond Like Carbon versehen ist.

12. Verwendung einer Nockenwelle nach Anspruch 9 oder 10 in Kombination mit einer Vielzahl von Stößeln oder Kipphebeln, die jeweils mit diesen Nocken zusammenwirken, wobei jeder der Stößel oder Kipphebel eine Kontaktfläche aufweist, die mit einer auf Kohlenstoff basierenden Beschichtung Diamond Like Carbon in Gegenwart eines Öls versehen ist, das auf Schwefel und Molybdän basierende reibungsmindernde Zusätze enthält.

13. Beschichtungsbehandlungsanlage zur Durchführung des Verfahrens nach einem der Ansprüche 1 bis 7, umfassend eine Beschichtungsmaterialquelle und einen Träger, der so angepasst ist, dass er vor dieser Quelle entlang eines relativen Laufbahn bewegt werden kann, wobei dieser Träger eine Vielzahl von Stäben umfasst, die parallel zueinander verlaufen, wobei diese Stäbe in Bezug auf diesen Träger fixiert sind, indem sie in im gleichen Abstand von der Laufbahn gleichmäßig verteilt sind, so dass sie senkrecht zur Emissionsrichtung der Beschichtungsmaterialquelle ausgerichtet sind, wenn sie sich der Quelle zuwenden, wobei die Anlage ferner Nocken umfasst, die eine zentrale Aussparung sowie einen Rand mit einer Kreisfläche und einem länglichen Abschnitt aufweisen, der eine Nase bildet und eine Länge aufweist, die durch die maximale Abmessung, gemessen von seiner Nase zu der Kreisfläche, definiert ist, wobei die Nocken auf dem Träger in einer festen und dichten Konfiguration angeordnet sind, indem die Stäbe durch die Aussparungen geführt sind, und wobei diese Stäbe einen solchen Abstand voneinander aufweisen, dass Nocken eines vorbestimmten Formats, die auf diesen Stäben in Eingriff sind, zumindest annähernd in Kontakt mit den Nocken stehen, sie auf den nächstgelegenen Stäben in Eingriff sind, während sie in Bezug auf die Laufbahn nach der gleichen Konfiguration ausgerichtet sind, wobei ihre Nasen zur Quelle hin ausgerichtet sind, wenn sie dieser Quelle gegenüber gelangen, so dass eine Beschichtung selektiv auf den Bruchteilen der Nockenränder, die zu der genannten Quelle hin ausgerichtet sind, höchstens auf der Nase der Nocken abgeschieden wird.

14. Anlage nach Anspruch 13, deren Träger ein Karussell ist, das so angepasst ist, dass es sich um eine Drehachse der Quelle dreht.

## Claims

1. Method for treating the cams of a camshaft for a vehicle with an internal combustion engine in order to reduce the friction thereof with respect to an opposing part in a zone provided with a hard coating based on amorphous carbon of the diamond-like carbon or DLC type, these cams having a central recess, an edge surface that has a circular zone and an elongated portion forming a nose having a length defined by the maximum dimension measured from their nose to the circular zone, according to which method the cams are arranged on a support, this support is brought into a chamber that is put under vacuum in order to perform cleaning of the cams, this support is put in relative motion following a path of travel relative to a source for the vacuum deposition of a hard-coating material based on amorphous carbon of the diamond-like carbon or DLC type and these cams are removed from the support before they are assembled onto a camshaft, **characterized in that**, this support comprising a plurality of rods parallel to one another, that are fixed with respect to this support and distributed regularly at one and the same distance from the path of travel and being oriented perpendicularly to the direction of emission of the source of coating material when they arrive opposite this source, the cams being arranged on the support in a fixed and dense configuration the rods passing through the openings, the rods being distributed regularly along this path in such a way that the cams engaged on a rod are at least approximately in contact with the cams engaged on the nearest rods, the cams in this fixed and dense configuration are brought successively, along this path of travel, opposite the coating source with substantially identical orientations and at substantially identical distances with respect to this source, so as to deposit a coating selectively on the fractions of the edge surfaces of the cams that are oriented towards said source, over at most the nose of the cams.

2. Method according to claim 1, in which the support is a carousel having an axis of rotation, and the cams are arranged on the carousel so as to align their lengths along the radii of this carousel, being at one and the same distance from the axis of rotation, and the movement applied to the carousel is a rotation about said axis.

3. Method according to claim 1, in which the support has a rectilinear path of travel, and the cams are arranged on this support so as to align their lengths parallel to one another, being at one and the same distance from this path of travel.

4. Method according to any one of claims 1 to 3, in which masks are arranged on the support, all arranged at one and the same distance with respect to a surface defined by the set of rods during their relative movements with respect to the source alternating with these rods, so as to be in front of these rods in the direction of the source when the rods and the cams arrive opposite the source, so as to mask, with respect to the source, the zones of the cams where their edge surfaces are opposite the adjacent cams.

5. Method according to any one of claims 1 to 4, in which the carbon-based coating with a composition containing from 20 to 50 at% of hydrogen is deposited.

6. Method according to any one of claims 1 to 5, in which, prior to deposition of the carbon-based coating, a sub-layer is formed in tungsten carbide or nitride, chromium carbide or nitride or a mixture of tungsten and chromium carbides and/or nitrides.

7. Method according to any one of claims 1 to 6, in which a microtextured surface is formed on all or part of the nose of the cams, before or after formation of the DLC coating.

8. Cam obtained by the method according to any one of claims 1 to 7, in which only a part of the edge surface, representing at most the nose of the cam, is provided with a coating based on amorphous diamond-like carbon.

9. Camshaft comprising cams obtained by the method according to any one of claims 1 to 7, in which only a part of the edge surface, representing at most the nose of these cams, is provided with a coating based on amorphous diamond-like carbon.

10. Camshaft according to claim 9, in which the edge surfaces of the cams are only provided with said coating up to a distance, with respect to the ends of the circular zone of the cams, that has a value of at least 30% of the radius of this circular zone of these cams.

11. Motorization assembly comprising a camshaft according to claim 9 or 10 and a plurality of tappets or finger followers cooperating respectively with these cams, each of these tappets or finger followers having a contact surface provided with a coating based on amorphous hard carbon (diamond-like carbon).

12. Use of a camshaft according to claim 9 or 10 in combination with a plurality of tappets or finger followers cooperating respectively with these cams, each of these tappets or finger followers having a contact surface provided with a carbon-based (diamond-like carbon) coating, in the presence of an oil containing friction-reducing additives based on sulphur and molybdenum.

13. Coating treatment facility for implementing the method of any one of claims 1 to 7, comprising a source of coating material, and a support able to be moved in front of this source following a path of relative travel, this support comprising a plurality of rods parallel to one another, these rods being fixed with respect to this support and distributed regularly at one and the same distance from the path of travel so as to be oriented perpendicularly to the direction of emission of the source of coating material when they arrive opposite this source, the facility further comprising cams having a central opening, an edge surface that has a circular zone and an elongated portion forming a nose while having a length defined by the maximum dimension measured from their nose to the circular zone, the cams being disposed on the support in a fixed and dense configuration with the rods passing through the openings, and the rods having a spacing between them such that cams of a predetermined format engaged on these rods are at least approximately in contact with the cams engaged on the nearest rods while being oriented according to one and the same configuration with respect to the path of travel with their noses being oriented towards the source when they arrive opposite this source, so as to deposit a coating selectively on the fractions of the edge surfaces of the cams that are oriented towards said source, over at most the nose of the cams.

14. Facility according to claim 13, in which the support is a carousel that is able to turn about an axis of rotation in front of this source.
